# EUROPEAN PATENT APPLICATION

(11) **EP 4 686 981 A1**
(43) Date of publication of application: **04.02.2026**
(21) Application number: 24191701.2
(22) Date of filing: 30.07.2024
(51) Int. Cl.: G03F 7/20

(54) **EXPOSURE METHOD AND EXPOSURE APPARATUS**

(71) Applicant: ASML Netherlands B.V., 5500 AH Veldhoven (NL)
(72) Inventor: THEEUWES, Thomas, 5500 AH Veldhoven (NL); MOS, Everhardus, Cornelis, 5500 AH Veldhoven (NL)
(74) Representative: ASML Netherlands B.V.

(57) **Abstract**

A new exposure method for forming a pattern on a plurality of target regions (e.g. fields) of a substrate (e.g. a wafer) is disclosed. The exposure method comprises providing a first object and a second object, such that the first object is adjacent to, and generally coplanar with, the second object. The exposure method also comprises at least one scanning exposure in which an image of the first object is formed on a first target region of the substrate and an image of the second object is formed on a second target region of the substrate, the first target region being separated from the second target region by a third target region. For at least part of the time when neither the first target region nor second target region overlaps with the second illumination region the substrate accelerates.

## Description

### FIELD

The present invention relates to an exposure method. The exposure method may comprise a lithographic exposure method. In particular, the exposure method has particular application for an extreme ultraviolet (EUV) lithographic process. The exposure method may be a scanning exposure method. The present invention also relates to an exposure apparatus (which may carry out the exposure method).

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask or a reticle) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

In general, a lithographic apparatus may be used to form a pattern on a plurality of target regions of a substrate. For example, a lithographic apparatus may be used to form the same pattern on a plurality of target regions (also referred to as fields) of a resist-coated silicon wafer. The pattern is typically defined by a patterning device (also referred to as a reticle or mask). Radiation is patterned by the reticle and then imaging optics are used to form an image of the pattern on the wafer. EUV lithographic reticles are typically reflective optical elements provided with a patterned coating that absorbs EUV radiation. The wafer may then be moved and the image can be formed on another field of the wafer and so on. The pattern may be transferred to the wafer during a scanning exposure in which the reticle is scanned through an illumination region (also referred to as a slit) while the wafer is also moved such that the image of the reticle is stationary with respect to the wafer.

It may be desirable to provide new exposure apparatus and/or exposure methods that improve existing arrangements. For example, it may be desirable to provide new exposure apparatus and/or exposure methods that improves throughput and/or accuracy relative to such existing arrangements. Additionally or alternatively, it may be desirable to provide new exposure apparatus and/or exposure methods that at least partially address one or more problems associated with existing arrangements whether such problems are identified herein or otherwise.

### SUMMARY

According to a first aspect of the present disclosure there is provided an exposure method for forming a pattern on a plurality of target regions of a substrate, the exposure method comprising: providing a first object defining a first portion of the pattern and a second object defining a second portion of the pattern, such that the first object is adjacent to, and generally coplanar with, the second object, the first object offset from the second object in a first direction; and at least one scanning exposure, the or each scanning exposure comprising: moving the first object and the second object in the first direction such that they sequentially scan through a first illumination region while the first illumination region is illuminated with radiation; and capturing radiation scattered by the first and second objects and using it to form an image of the first and second objects in a second illumination region while moving the substrate through the second illumination region such that an image of the first object is formed on a first target region of the substrate and an image of the second object is formed on a second target region of the substrate; wherein the first target region is separated from the second target region by a third target region; and wherein for at least part of the time when neither the first target region nor second target region overlaps with the second illumination region the substrate accelerates.

The exposure method according to the first aspect of the present disclosure may comprise a lithographic exposure method. The first object and the second object may comprise any type of patterning device (also referred to as a reticle or mask). The first illumination region may be disposed in an object plane (which may also referred to as a reticle-level illumination region). The second illumination region may be disposed in an image plane (which may also referred to as a wafer-level illumination region). The first and/or second illumination region may be referred to as a slit (or exposure slit).

During the exposure method a pattern may be formed on a plurality of target regions of a substrate. For example, the same pattern may be formed on a plurality of target regions (also referred to as fields) of a resist-coated silicon wafer. The pattern is defined by the first and second objects, which each act as a patterning device (also referred to as a reticle or mask). Radiation is patterned by these objects and then imaging optics may be used to form an image of each one on the wafer. The pattern is transferred to the wafer during a scanning exposure in which the first and second objects are scanned through the first illumination region while the wafer is also moved such that the image of each of the first and second objects is stationary with respect to the wafer.

Within the lithographic field, reticles are expensive to manufacture. Reticles are typically formed from a reticle blank and reticle blanks are typically of a standard size (referred to as a 6" reticle blank). A first generation of EUV lithographic apparatus (also referred to as scanners) used spherical imaging optics with a reduction factor of 4 to form an image of a reticle (formed from a standard 6" reticle blank) that was reduced in both dimensions by the factor of 4. In order to increase the resolution of EUV lithography, the imaging optics of the next generation of EUV lithographic apparatus will have an increased numerical aperture (NA). Since EUV reticles are reflective, the EUV radiation is not normal to the reticle but rather is incident at a non-zero angle to a normal of the reticle in one direction (so that the incoming cone of radiation that is incident on the reticle is separate from the outgoing cone of radiation scattered by the reticle and which is accepted by the imaging optics). This direction is typically the scanning direction of the lithographic apparatus. In this direction, there is a limit to the extent to which the cone of radiation of the incoming radiation can be enlarged without overlapping the scattered cone of radiation (unless the angle of incidence of the chief ray of the incoming radiation is increased). However, it is undesirable to increase the angle of incidence of the chief ray of the incoming radiation as this will increase 3D effects of the reticle, reducing contrast. Therefore, it has been proposed to use anamorphic imaging optics in the next generation of EUV lithographic apparatus such that, in the scanning direction, the reduction factor of the imaging optics is 8 whereas in the non-scanning direction the reduction factor remains 4 and the cone of light is enlarged only in the non-scanning direction.

However, one consequence of the increased reduction factor is that the field of view that can be imaged with a standard 6" reticle is now halved.

It may be desirable to form a pattern that is larger than the size that can be imaged with existing reticles (especially in the next generation of EUV lithographic apparatus using anamorphic imaging optics). Therefore, in some systems, each target region (field) may be exposed using two reticles, each of which defines the pattern of half of the field. However, such a half-field design increases the number of field-steps that need to be taken in order to expose the entire wafer and therefore reduces the throughput of the lithographic apparatus as compared to a full-field system (in which the pattern of the entire field is defined by a single reticle). By default, the wafer is exposed in two steps and a (slow) reticle swap is performed in between. This further reduces throughput of the system. The second exposure with the second reticle can be done in at least two different ways. A first method involves keeping the wafer on a wafer stage and, once each field has been exposed using the first reticle, exchanging the reticle and exposing the wafer for the second time. However, this is very slow. A second method involves exposing a whole lot of wafers (e.g. 25 wafers) with one reticle, exchanging the reticle and then involves exposing the whole lot of wafers again. This can increase the throughput relative to the first method, however, the wafer is clamped on the wafer stage for less time each time it is exposed, which can limit the available time for measurements to be made once the wafer has been clamped and before it is exposed (without again negatively impacting the lithographic throughout). For example, the available measurement time may be reduced by a factor of 2 since only half the amount of fields are exposed per wafer pass. As a consequence, the number of alignment marks that can be measured is halved. In addition, a buffer (also referred to as a stocker) is required to temporarily store the entire lot of wafers in between the first and second exposures.

Instead of exposing two half-fields separately as two different steps, with the exposure method of the first aspect both reticles are exposed in a single stroke. Advantageously, this results in a measurement time that is comparable to that of the first generation of EUV lithographic apparatus (and therefore does not significantly reduce the number of alignment marks that can be measured). An image of the first object (reticle) is formed on a first target region (field) of the substrate and an image of the second object (reticle) is formed on a second target region (field) of the substrate, the first and second target regions being separated by a third target region. In between the formation of the images of first and second objects the wafer is moved such that the third target region traverses the second illumination region. Advantageously, by accelerating the substrate for at least part of the time when neither the first target region nor second target region overlaps with the second illumination region the throughput of the method is increased.

The two objects (reticles) can remain clamped to a reticle clamp during exposures of multiple lots of wafers. Both reticles are exposed during one scanning motion, with a short acceleration cycle between the two exposures.

The image of the first object may be formed on a portion of the first target region of the substrate that is adjacent to the third target region and the image of the second object may be formed on a portion of the second target region that is adjacent to the third target region.

For example, each target region may comprise two portions that are mutually adjacent in the first direction. Each of the two portions may comprise around a half of the target region.

The first object and the second object may be provided such that a gap between them in the first direction is greater than an extent of the first illumination region in the first direction.

That is, the entire first illumination region can be disposed within the gap between the first and second objects. With such an arrangement, there is no temporal overlap between the formation of the images of the first and second objects. Advantageously, this allows for the first illumination region to be masked (for example using reticle masking blades) in between the formation of the first and second images. This may reduce the risk that the third target region is exposed to stray radiation.

The first object and the second object may be provided such that a gap between them in the first direction is less than a combined extent of the first object and the second object in the first direction.

Advantageously, such an arrangement allows for the movement of the first object and the second object in the first direction to be at a constant velocity, despite the fact that for at least part of the time when neither the first target region nor second target region overlaps with the second illumination region the substrate accelerates, as now discussed. It is particularly advantageous for the movement of the first object and the second object in the first direction to be at a constant velocity, particularly within a lithographic apparatus which applies a reduction factor. For example, for a lithographic apparatus having imaging optics that applies a reduction factor of 8 in the scanning direction, the first and second objects (the reticles) will already be moving 8 times faster than the substrate (wafer). Therefore, any acceleration of the objects (reticles) will, in general, require significantly higher forces and energy to accelerate than the substrate (wafer) and, in turn, this results in a higher risk of dynamic errors.

The extent of the first object in the first direction may be substantially equal to the extent of the second object in the first direction. An extent of the images of the first object and second objects in the first direction may be substantially equal to half of an extent of the plurality of target regions (fields) in the first direction.

As explained above, the method according to the first aspect may be used to expose half of a first field with a first object (for example defining pattern having extent A) and half of a second field with a second object (for example defining pattern having extent B). At wafer-level, the images of the first object and second objects are separated by A'+B'+2g', where A' is the extent of the first object at wafer level, B' is the extent of the second object at wafer level and g' is an extent of a gap between two adjacent fields (also referred to as a scribe line) at wafer level. Since g'<<A' and g'<<B' the distance between images of the first object and second objects is approximately A'+B'.

Since, for at least part of the time when neither the first target region nor second target region overlaps with the second illumination region the substrate accelerates, for the movement of the first object and the second object in the first direction to be at a constant velocity, the gap, Δy, between the first object and the second object in the first direction should be less than a combined extent of the first object and the second object in the first direction (i.e. Δy<A+B).

The substrate may comprise a plurality of target regions. The or each target region may be substantially rectangular. The plurality of target regions may comprise a two-dimensional array of target regions. A plurality of target regions that are at substantially the same position in the first direction may be referred to as a row of target regions. A plurality of target regions that are at substantially the same position in a second direction that is generally perpendicular to the first direction may be referred to as a column of target regions.

The method may comprise a plurality of scanning exposures.

The plurality of scanning exposures may result in an image of the first object and an image of the second object being formed in each of a plurality of target regions.

For each of the plurality of target regions, a scanning direction used to form the image of the first object may be the same as the scanning direction used to form the image of the second object.

The plurality of target regions may comprise a two-dimensional array of target regions.

The image of the first object formed on a target region of the substrate during one scanning exposure may be stitched to the image of the second object formed on that target region of the substrate during another scanning exposure.

The images of the first object and the second object that are stitched may be mutually adjacent in the first direction.

That is, the two images that are stitched are mutually adjacent in the scanning direction. Put differently, a join line between the two images that are stitched extends in a second direction (a non-scanning direction).

The image of the first object formed on a target region of the substrate during one scanning exposure and the image of the second object formed on that target region of the substrate during another scanning exposure may be formed using the same scanning direction. Advantageously, this may allow for the more accurate stitching between the two images to be achieved. This may be because when the same scanning direction is used the stitching may be less affected by heating of the substrate and any distortion that results from this heating.

At least two sequential scanning exposures of the plurality of scanning exposures may comprise: forming an image of the first object on a target region from a first row of target regions of the substrate and forming an image of the second object on a target region from a second row of target regions of the substrate.

In some embodiments, the at least two sequential scanning exposures of the plurality of scanning exposures may comprise forming an image of the first object on all of the target regions from the first row of target regions of the substrate and forming an image of the second object on all of the target regions from the second row of target regions of the substrate.

The at least two sequential scanning exposures of the plurality of scanning exposures may be performed as a meander scan. That is, the movement of the substrate during one of the at least two sequential scanning exposures of the plurality of scanning exposures may be in an opposite direction to movement of the substrate during the preceding one of the at least two sequential scanning exposures of the plurality of scanning exposures.

The method may comprise a first set of sequential scanning exposures of the plurality of scanning exposures and each of the first set of sequential scanning exposures may comprise: forming an image of the first object on a target region from a first row of target regions of the substrate and forming an image of the second object on a target region from a second row of target regions of the substrate.

The first set of sequential scanning exposures may form an image of the first object on substantially all of the target regions of the first row of target regions and may form an image of the second object on substantially all of the target regions of the second row of target regions.

The method may comprise a plurality of sets of sequential scanning exposures of the plurality of scanning exposures. Each scanning exposure from a given one of the plurality of sets of sequential scanning exposures may comprise: forming an image of the first object on a target region from a first row of target regions of the substrate and forming an image of the second object on a target region from a second row of target regions of the substrate. Scanning exposures from different sets of sequential scanning exposures may comprise: forming an image of the first object on target regions from different rows of target regions of the substrate and forming an image of the second object on target regions from different rows of target regions of the substrate.

In this way, a plurality of rows of target regions may be exposed to images of both the first and second objects. A given target region (for example from a central portion of the substrate) may be exposed to an image of the first object during an exposure from one of the sets of sequential scanning exposures and may be exposed to an image of the second object during an exposure from another one of the sets of sequential scanning exposures.

A movement of the substrate during one of the at least two sequential scanning exposures and/or the one of the plurality of sets of sequential scanning exposures of the plurality of scanning exposures may be in an opposite direction to a movement of the substrate during the preceding one of the at least two sequential scanning exposures and/or the first set of sequential scanning exposures of the plurality of scanning exposures.

At least two sequential scanning exposures of the plurality of scanning exposures may comprise: forming an image of the first object on target regions from different rows of target regions of the substrate and forming an image of the second object on target regions from different rows of target regions of the substrate.

In general, each target region is exposed to an image of a first object during a first scanning exposure and exposed to an image of a second object during a second scanning exposure.

At least one scanning exposure of the plurality of scanning exposures may comprise: forming an image of the first object or the second object on a target region of the substrate.

That is, at least one scanning exposure only involves forming the image of one of the two objects on the substrate. For example one or more rows of target regions may be exposed to the images of the first or second objects using such exposure processes.

In some embodiments, target regions from a plurality of rows of target regions in a central portion of the substrate may be exposed using: (a) a first scanning exposure in which an image of first object is formed on that target region and an image of the second object is formed on another target region; and (a) a second scanning exposure in which an image of second object is formed on that target region and an image of the first object is formed on yet another target region. As used here the first and second scanning exposures may be performed in any order.

However, for any given column of target regions on a substrate (i.e. any line of target regions extending in the first direction or scanning direction) two target regions at each end of the column may be exposed using: (a) a first scanning exposure in which an image of one of the first and second objects is formed on that target region and an image of the other one is formed on another target region; and (a) a second scanning exposure in which only an image of the other one of the first and second objects is formed on that target region. Again, as used here the first and second scanning exposures may be performed in any order.

The method may comprise a second set of sequential scanning exposures of the plurality of scanning exposures, which may each comprise: forming an image of only the first object or the second image on a target region from a first row of target regions of the substrate.

A plurality of columns of target regions may be exposed to an image of the first object and an image of the second object. For two target regions at each end of each column the image of one of the first or second objects may be formed during a scanning exposure in which only said image of one of the first or second objects is formed.

For the or each scanning exposure in which an image of the first object is formed on a first target region of the substrate and an image of the second object is formed on a second target region of the substrate, the first target region being separated from the second target region by a third target region, when neither the first target region nor second target region overlaps with the second illumination region the substrate may accelerate from an exposure scanning speed to a higher speed and then back down to the exposure scanning speed.

According to a second aspect of the present disclosure there is provided an exposure apparatus comprising: a first object support configured to support a first object; a second object support configured to support a second object; and a controller operable to implement the method of the first aspect of the present disclosure.

The exposure apparatus according to the second aspect of the present disclosure may comprise any features of the method of the first aspect of the present disclosure described above.

### BRIEF DESCRIPTION OF THE DRAWINGS

Embodiments of the invention will now be described, by way of example only, with reference to the accompanying schematic drawings, in which:

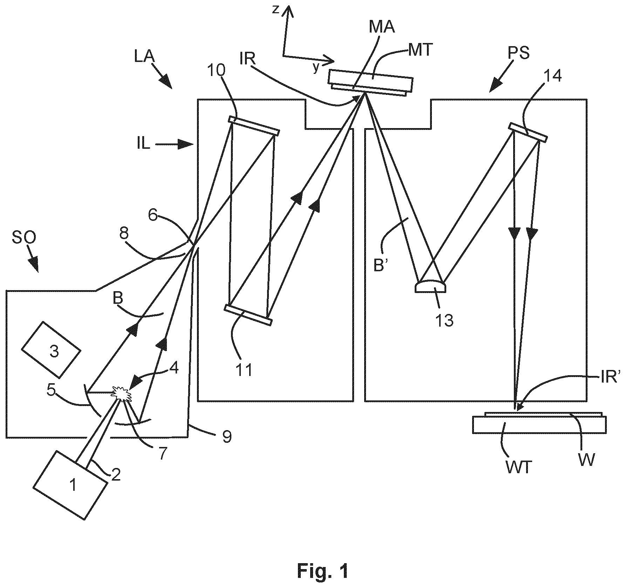

- Figure 1 depicts a lithographic system comprising a lithographic apparatus and a radiation source;

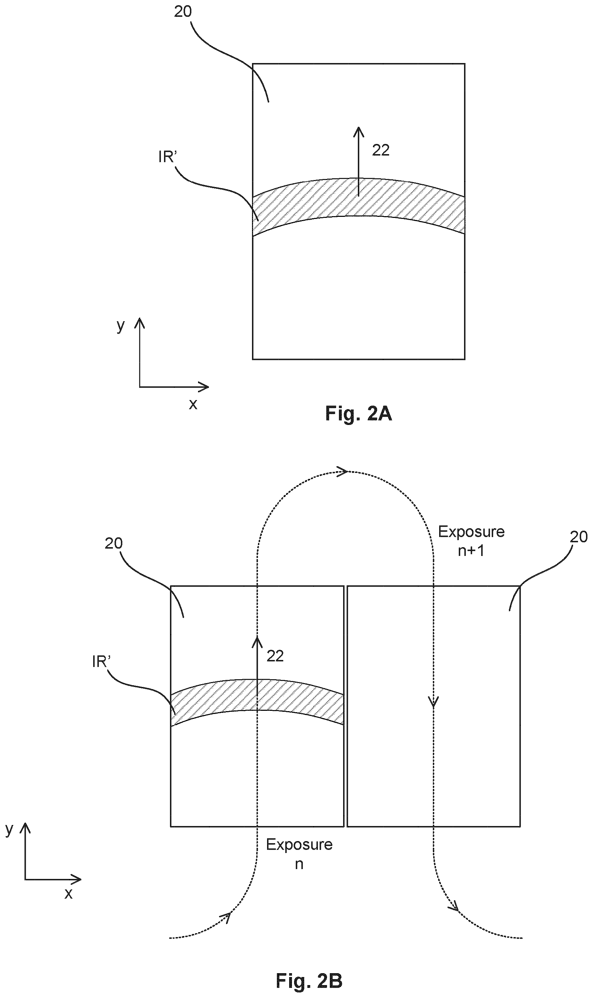

- Figure 2A is a schematic representation of a single target region of a wafer, showing both: (a) a shape of the target region; and (b) a shape of a wafer-level illumination region;

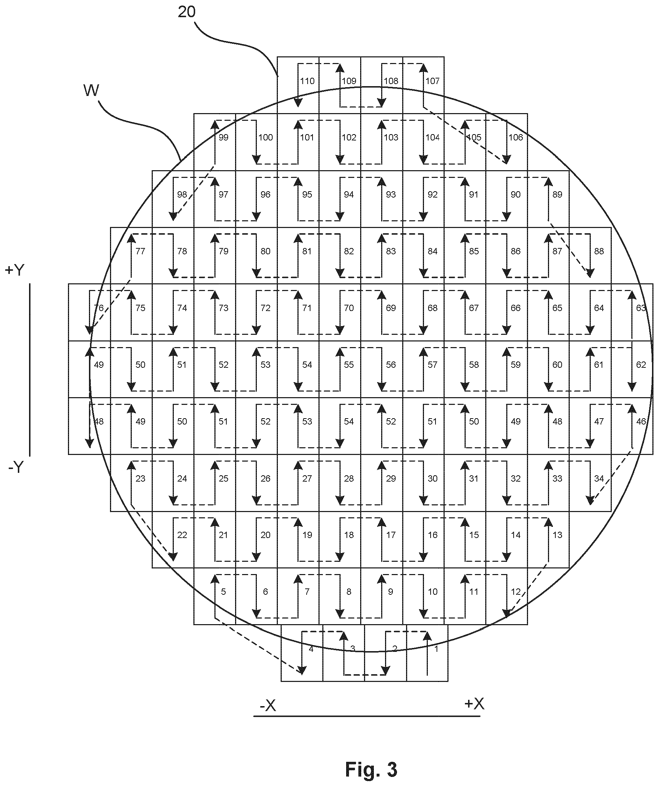

- Figure 2B schematically shows two adjacent target regions of a wafer which are exposed sequentially using two opposite scan directions; these two consecutive exposures may form part of a meander scan, for example a meander scan of the type shown in Figure 3;
- Figure 3 is a schematic plan view representation of a (generally circular) substrate comprising a plurality of (generally rectangular) target regions or dies; also shown is a standard meander scan pattern in which each row of target regions (extending in a non-scanning direction) is exposed in turn, with the order of the exposure of the target regions indicated by a number on each target region, the scanning direction of the exposure of each target region is indicated by a solid arrow and the movement of the substrate in between exposure of two consecutive target regions is indicated by dashed lines;

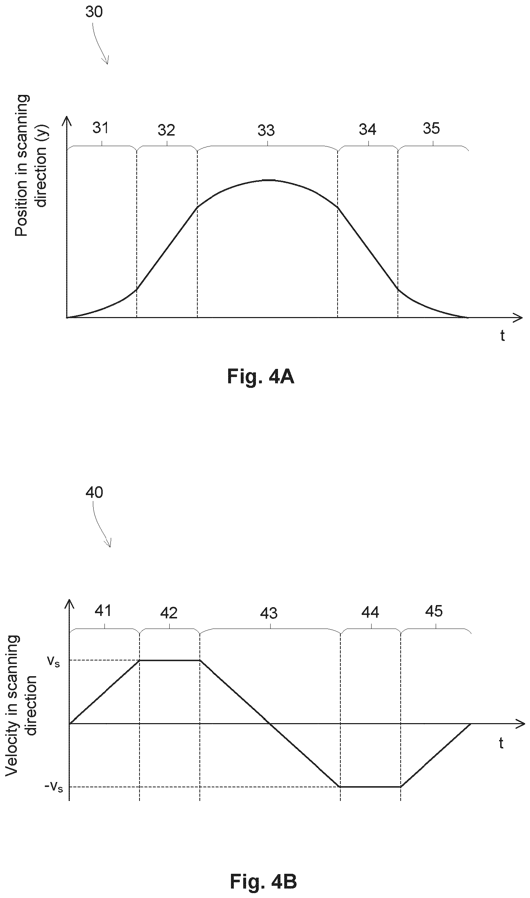

- Figure 4A shows a graph that represents the position in the scanning direction (i.e. in the y-direction) of the reticle or wafer as a function of time during exposure of two successive target regions in the same row of target regions during a meander scan of the type described above with reference to Figures 2B and 3;
- Figure 4B shows a graph that represents the velocity in the scanning direction (i.e. in the y-direction) of the reticle or wafer as a function of time during exposure of two successive target regions in the same row of target regions during a meander scan of the type described above with reference to Figures 2B and 3;

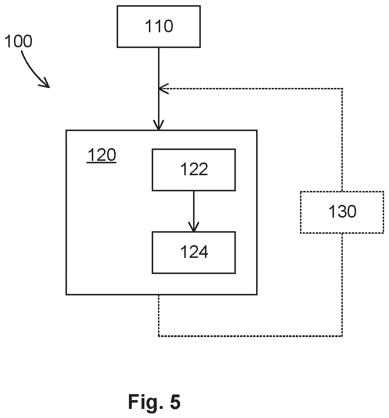

- Figure 5 is a schematic illustration of a new exposure method for forming a pattern on a plurality of target regions of a substrate according to an embodiment of the present disclosure;

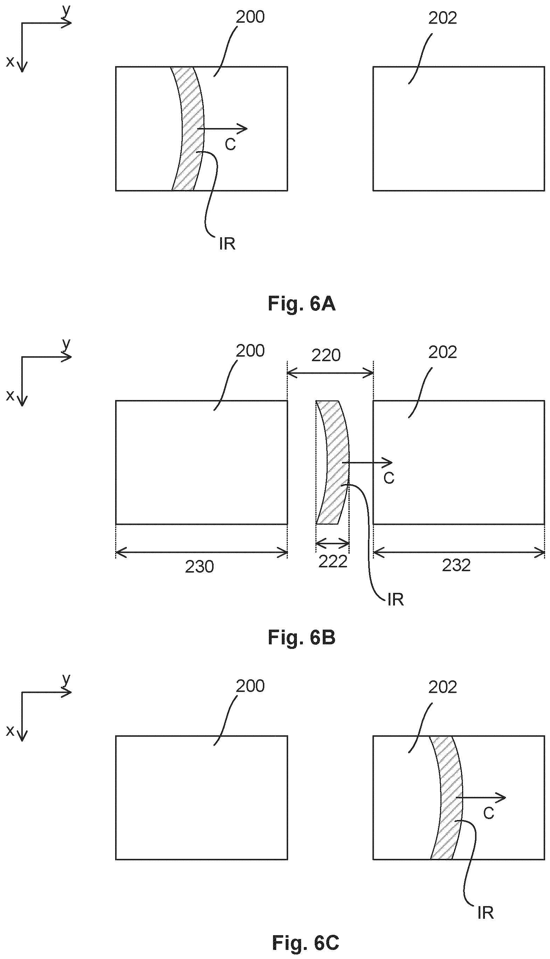

- Figure 6A schematically shows an arrangement of two objects (for example reticles) and a first (or reticle-level) illumination region at a first point during a scanning exposure of the new exposure method shown in Figure 5;
- Figure 6B schematically shows an arrangement of two objects (for example reticles) and a first (or reticle-level) illumination region at a second point during a scanning exposure of the new exposure method shown in Figure 5;
- Figure 6C schematically shows an arrangement of two objects (for example reticles) and a first (or reticle-level) illumination region at a third point during a scanning exposure of the new exposure method shown in Figure 5;

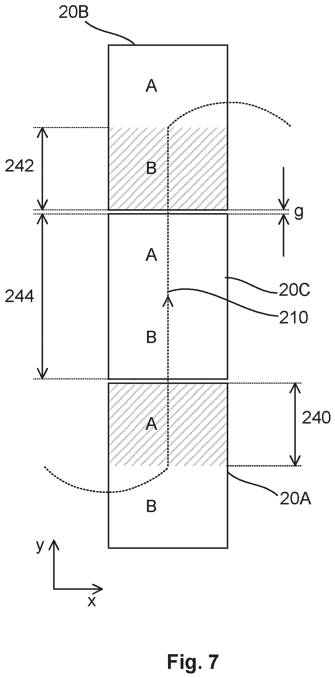

- Figure 7 is a schematic illustration of an example path of a second (or wafer-level) illumination region over a portion of a wafer comprising three target regions (fields) during a modified type of meander scan that may form part of the new exposure method shown in Figure 5;

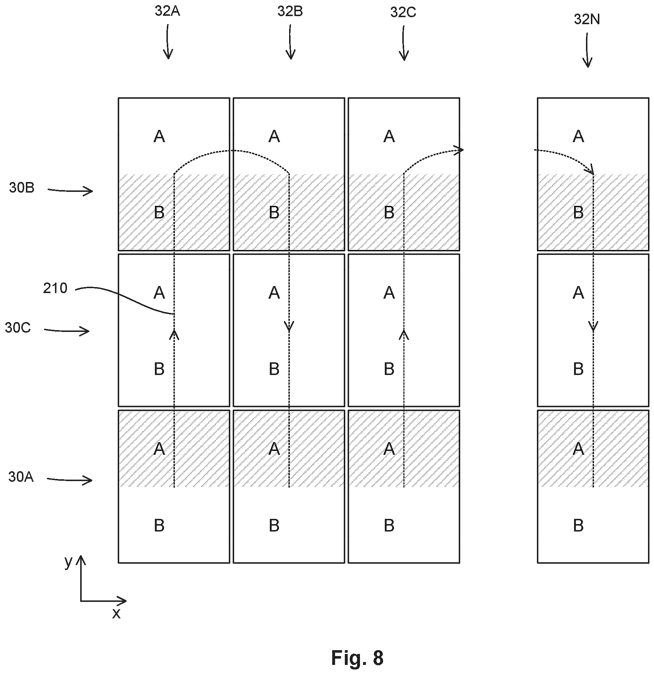

- Figure 8 schematically shows a plurality of rows of target regions (fields) on a wafer and illustrates a first set of scanning exposures that may form part of the new exposure method shown in Figure 5; portions of the target regions on which the images of first and second objects are being formed are shaded;

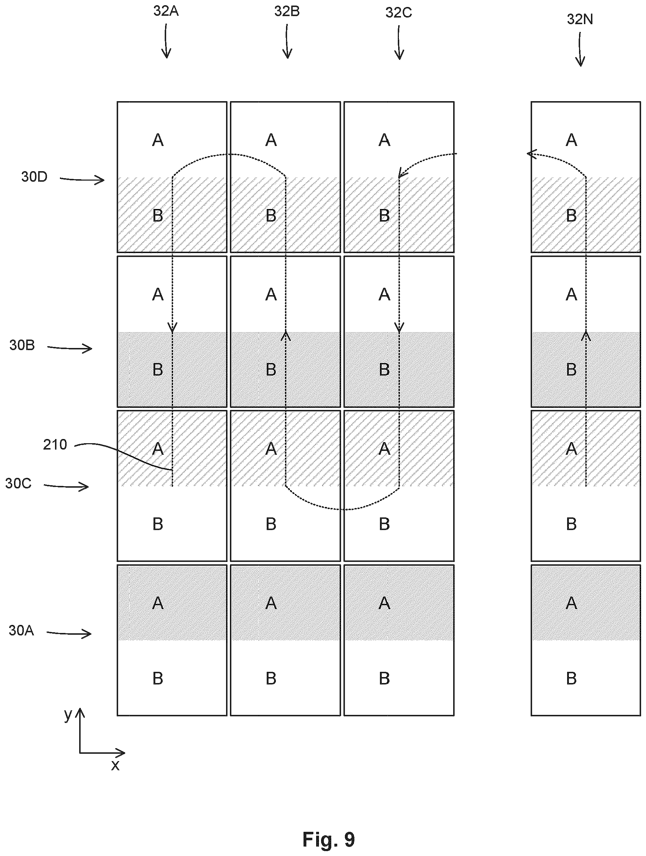

- Figure 9 schematically shows the plurality of rows of target regions (fields) on a wafer that are shown in Figure 8 and illustrates a second set of scanning exposures that may form part of the new exposure method shown in Figure 5; portions of the target regions on which the images of first and second objects are being formed are shaded; portions of the target regions that have already been exposed during the first set of scanning exposures (cf. Figure 8) are shown in grey;

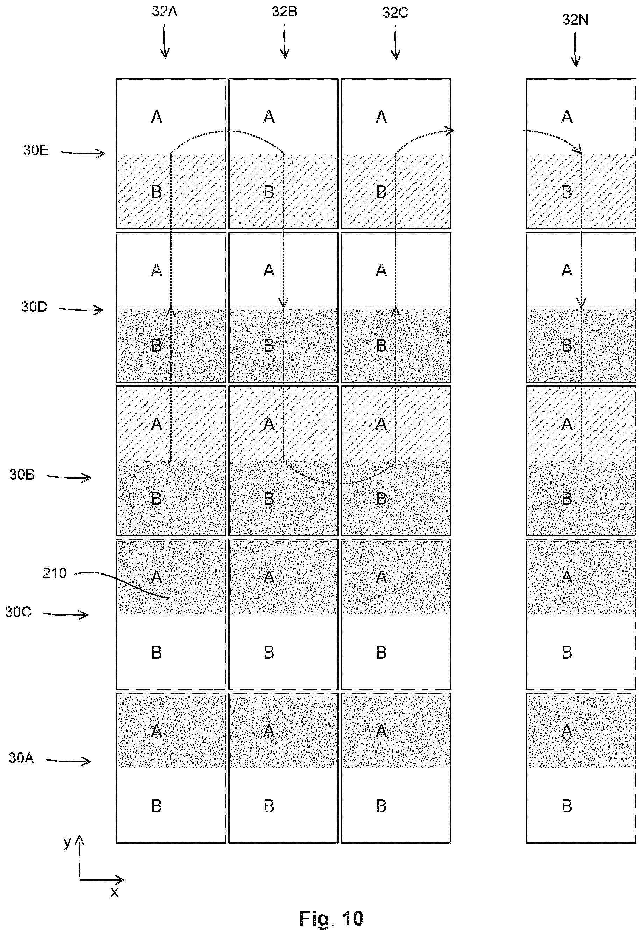

- Figure 10 schematically shows the plurality of rows of target regions (fields) on a wafer that are shown in Figures 8 and 9 and illustrates a third set of scanning exposures that may form part of the new exposure method shown in Figure 5; portions of the target regions on which the images of first and second objects are being formed are shaded; portions of the target regions that have already been exposed during the first and second sets of scanning exposures (cf. Figures 8 and 9) are shown in grey;

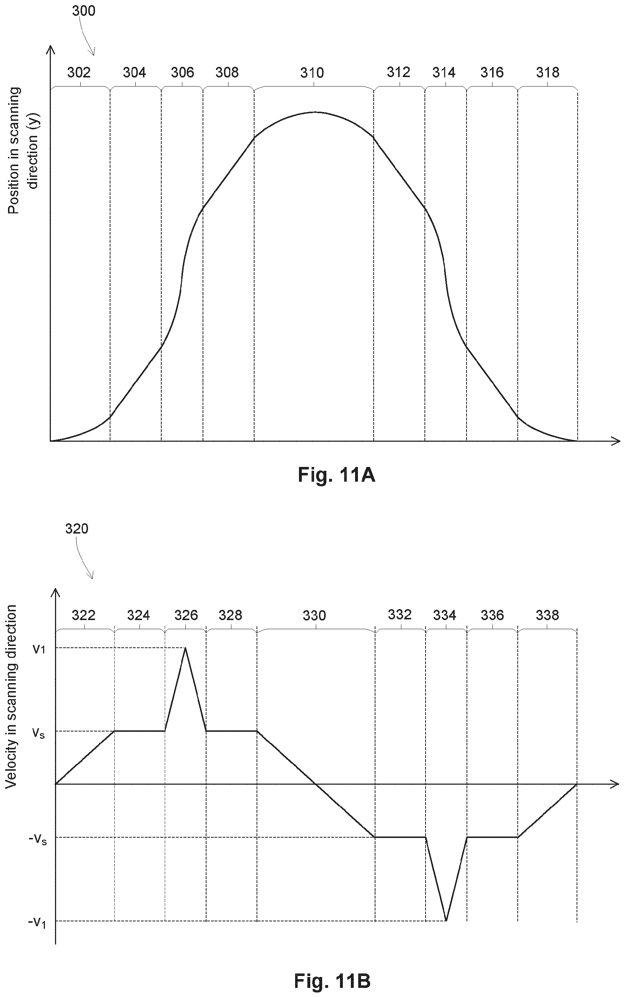

- Figure 11A shows a graph that represents the position of a substrate (wafer) as a function of time during two successive scanning exposures of the new method shown in Figure 5 from the same set of successive scanning exposures during a meander scan of the type described above with reference to Figures 8 and 10;
- Figure 11B shows a graph that represents the velocity in the scanning direction (i.e. in the y-direction) of the substrate (wafer) as a function of time during exposure of two successive scanning exposures of the method shown in Figure 5 from the same set of successive scanning exposures during a meander scan of the type described above with reference to Figures 8 and 10;

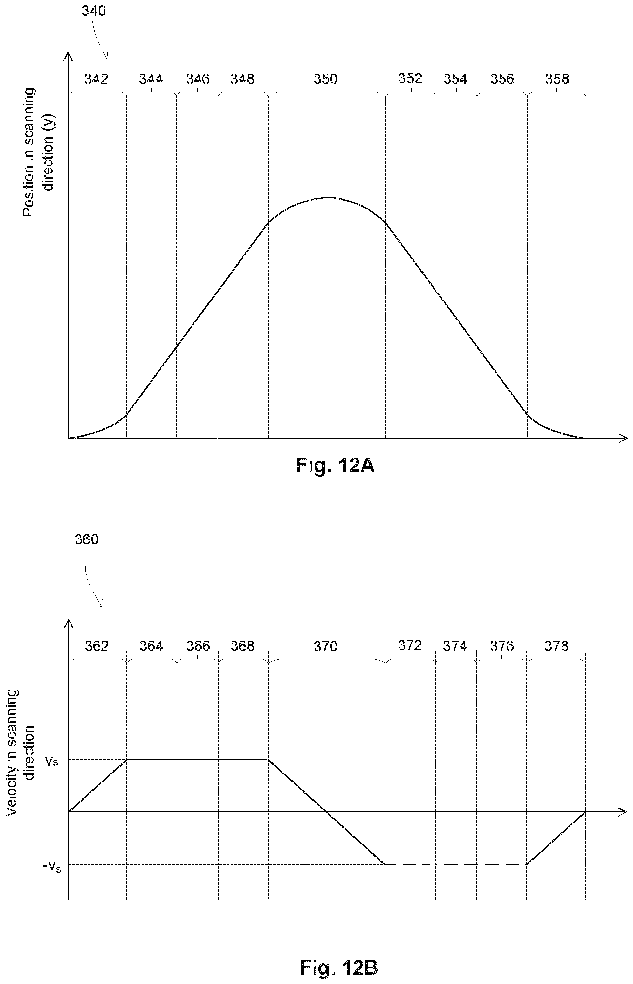

- Figure 12A shows a graph that represents the position of a reticle stage (that supports the two objects) as a function of time during two successive scanning exposures of the method shown in Figure 5 from the same set of successive scanning exposures during a meander scan of the type described above with reference to Figures 8 and 10;
- Figure 12B shows a graph that represents the velocity in the scanning direction (i.e. in the y-direction) of the reticle stage (that supports the two objects) as a function of time during exposure of two successive scanning exposures of the method shown in Figure 5 from the same set of successive scanning exposures during a meander scan of the type described above with reference to Figures 8 and 10; and

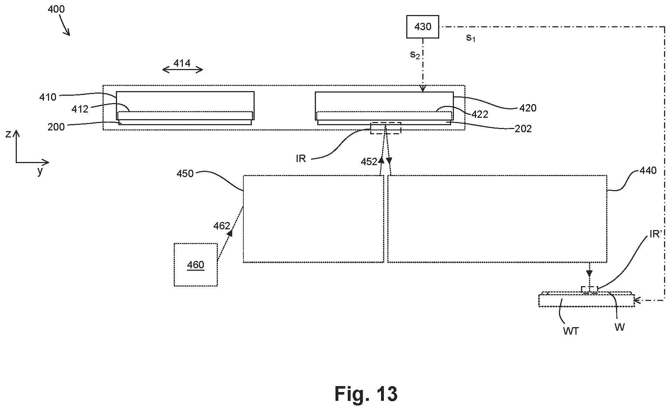

- Figure 13 is a schematic illustration of a new exposure apparatus for forming a pattern on a plurality of target regions of a substrate according to an embodiment of the present disclosure.

### DETAILED DESCRIPTION

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g., six or eight mirrors).

The substrate W may include previously formed patterns. Where this is the case, the lithographic apparatus LA may be operable to align the image formed by the patterned EUV radiation beam B' with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

The faceted field mirror device 10 and the faceted pupil mirror device 11 are arranged to provide a desired angular distribution of the radiation beam B, at the patterning device MA, as well as a desired uniformity of radiation intensity at the patterning device MA. The illumination system IL may be arranged to provide Kohler illumination of an illumination region IR (that the patterning device MA may be moved through during exposure of a substrate W) such that the plasma at the plasma formation region 4 is out of focus (and therefore does not influence properties of the radiation beam) at the patterning device MA and in the conjugate plane of the substrate W. As used herein, the illumination region IR may also be referred to as the illumination slit or the slit.

The illumination region IR is in a field plane in which the reticle MA is disposed during a lithographic exposure. Therefore, the illumination region IR may be referred to as a reticle-level or object-level illumination region IR. The reticle-level illumination region IR may be referred to as a first illumination region IR. It will be appreciated that projection system PS forms an image IR' of the illumination region IR in the plane of the substrate W. The image IR' of the illumination region IR in the plane of the substrate W may be referred to as a wafer-level or image-level illumination region IR'. As used herein, the wafer-level illumination region IR' may also be referred to as the slit. The wafer-level illumination region IR' may be referred to as a second illumination region IR.

The lithographic apparatus LA may be a scanning lithographic apparatus (also referred to as a scanner) and the image (of a reticle MA) may be formed during a scanning exposure. In such an exposure, the reticle MA may be moved in a scanning direction through the reticle-level illumination region IR. It will be appreciated that, as a result of this movement of the reticle MA, the image of the reticle MA will move at wafer level. Therefore, during the scanning exposure, the wafer W is also moved through the wafer-level illumination region IR'. In particular, the wafer W is moved so that the image of reticle MA is substantially static with respect to the wafer W. The movement of the reticle MA and the substrate W are therefore synchronized. The movement (speed and direction) of the substrate W will be dependent on the movement of the reticle and the imaging performed by the projection system PS. In some embodiments, the projection system PS may form an inverted image of the reticle MA and therefore the substrate W may be moved in an opposite direction to the reticle MA. In some embodiments, the projection system PS may apply a reduction factor to the patterned EUV radiation beam B' in the scanning direction and therefore the substrate W may move at a speed that is smaller than the speed of the reticle MA by this reduction factor.

The lithographic apparatus LA may be of a type having two or more substrate supports WT (also named "dual stage" or "multiple stage" machines). In such multiple stage machine, the substrate supports WT may be used in parallel, and/or steps in preparation of a subsequent exposure of the substrate W may be carried out on the substrate W located on one of the substrate support WT while another substrate W, on the other substrate support WT, is being used for exposing a pattern on the other substrate W.

For example in a dual stage machine, while an nth wafer is being exposed on one of the stages, an (n + 1)th wafer is disposed on the other stage and various measurements are made in order to improve the accuracy of the lithographic process. Such measurements may be referred to generally as a metrology step or stage. Such measurements include, for example, measurements of the positions of alignments marks (used to help ensure the image formed in the lithographic process is well aligned to previously formed process layers). Another example of such a measurement includes a measurement of the topology of the wafer W, for example, measured using a level-sensor (used dynamically during the subsequent exposure of that wafer to keep the surface of the wafer as close to a plane of best focus as possible).

In general, for the accuracy of the subsequent lithographic exposure, it is desirable to increase the number of measurements taken during the metrology stage. On the other hand, it is desirable to increase the throughput of the lithographic apparatus LA (i.e. the speed at which wafers are exposed, for example number of wafers per hour). In practice, in order to maximize throughput, the time available for the metrology stage is limited to the time taken to expose the previous wafer such that as soon as one wafer has been exposed the next wafer has already been measured and is ready to be exposed.

Figure 2A shows schematically a single target region 20 of a wafer W. A shape of the target region 20 is generally rectangular. Also shown in Figure 2A is the wafer-level illumination region IR' and a direction in which the wafer-level illumination region IR' effectively scans over the target region 20 is indicated by arrow 22. It will be appreciated that, in practice this may be achieved by scanning the target region 20 through the wafer-level illumination region IR' in a direction opposite to the arrow 22.

As shown in Figure 2B, in some known arrangements two adjacent target regions 20 may be exposed sequentially, as an nth exposure and an (n + 1)th exposure. The wafer W may be moved such that a direction in which the wafer-level illumination region IR' effectively scans over the target region 20 (indicated by dotted arrow 22) is in a first direction for the nth exposure and in an opposite direction for the (n + 1)th exposure.

The arrangement shown in Figure 2B may form part of a meander scan, which is now described with reference to Figure 3. Figure 3 is a schematic plan view representation of a (generally circular) substrate W comprising a plurality of (generally rectangular) target regions 20 or dies. In the embodiment shown in Figure 3 the substrate W comprises 110 target regions 20.

Forming an image of a reticle MA on a substrate a plurality of times may comprise forming an image of the reticle MA on a plurality of target regions 20 of the substrate W. Each of the plurality of target regions 20 may be generally rectangular. The plurality of target regions 20 may be arranged as a two-dimensional array.

In some embodiments, the two-dimensional array of target regions 20 may be exposed using a standard meander scan pattern in which each row of target regions 20 (extending in a non-scanning direction; the x-direction in Figure 3) is exposed in turn. Such a standard meander scan pattern is illustrated in Figure 3, with the order of the exposure of the target regions 20 indicated by a number on each target region. The scanning direction 22 of the exposure of each target region 20 is indicated by a solid arrow and the movement of the substrate W in between exposure of two consecutive target regions 20 is indicated by dashed lines.

Figure 4A shows a graph 30 that represents the position in the scanning direction (i.e. in the y-direction) of the reticle MA or wafer W as a function of time during exposure of two successive target regions in the same row of target regions during a meander scan of the type described above with reference to Figures 2B and 3. Similarly, Figure 4B shows a graph 40 that represents the velocity in the scanning direction (i.e. in the y-direction) of the reticle MA or wafer W as a function of time during exposure of two successive target regions in the same row of target regions during a meander scan of the type described above with reference to Figures 2B and 3. In particular, the graphs 30, 40 shown in Figures 4A and 4B represent the position and velocity in the y-direction for a portion of a meander scan represented by the dotted line in Figure 2B.

A first portion 31, 41 of each the graphs 30, 40 represents a portion of the meander scan during which the reticle MA or wafer W accelerates from rest at one end of the scanning motion. During this first portion the reticle MA or wafer W accelerates from rest (i.e. zero speed) up to a scanning speed, *vₛ,* in a first direction (the positive y-direction).

A second portion 32, 42 of each the graphs 30, 40 represents a portion of the meander scan during which a first target region 20 is exposed (for example the left-hand target region 20 in Figure 2B). During the second portion 32, 42 of each the graphs 30, 40 the reticle MA or wafer W moves at constant speed (the scanning speed *vₛ*).

A third portion 33, 43 of each the graphs 30, 40 represents a portion of the meander scan during which the reticle MA or wafer W decelerates from moving at the scanning speed, *vₛ,* in the first direction (positive y-direction) to rest and then accelerates from rest up to the scanning speed, *vₛ,* in a second direction (the negative y-direction).

A fourth portion 34, 44 of each the graphs 30, 40 represents a portion of the meander scan during which a second target region 20 is exposed (for example the right-hand target region 20 in Figure 2B). During the fourth portion 34, 44 of each the graphs 30, 40 the reticle MA or wafer W moves at constant speed (the scanning speed *vₛ*).

A fifth portion 35, 45 of each the graphs 30, 40 represents a portion of the meander scan during which the reticle MA or wafer W deaccelerates from the scanning speed, *vₛ,* in the second direction (the negative y-direction) to rest.

Some embodiments of the present disclosure relate to exposure methods (for example using EUV lithography apparatus LA of the type shown in Figure 1 and described above) which uses two objects (for example reticles or patterning devices MA) simultaneously. For example, an EUV lithography apparatus LA may comprise a reticle stage that can support two reticles in series (i.e. side by side or adjacent each other). Alternatively, an EUV lithography apparatus LA may comprise two reticle stages that can each support a reticle such that the two reticles are adjacent each other and which can move synchronously.

Some embodiments of the present disclosure relate to a new exposure method for forming a pattern on a plurality of target regions 20 of a substrate W. An example of such a new exposure method 100 for forming a pattern on a plurality of target regions 20 of a substrate W is shown schematically in Figure 5. Furthermore, an arrangement of two objects 200, 202 (for example reticles) that may be used by the new exposure method 100 is shown in Figures 6A to 6C. An example path 210 of a second (or wafer-level) illumination region IR' over a portion of a wafer W comprising three target regions 20A, 20B, 20C is shown in Figure 7. As explained above with reference to Figures 2A and 2B, it will be appreciated that, in practice, this path 210 may be achieved by scanning the substrate W through the wafer-level illumination region IR' in a direction opposite to the path 210 shown in Figure 7.

The exposure method 100 comprises a step 110 of: providing a first object 200 defining a first portion of the pattern and a second object 202 defining a second portion of the pattern, such that the first object 200 is adjacent to, and generally coplanar with, the second object 202, the first object offset from the second object in a first direction (the y-direction in Figures 6A to 6C).

The exposure method 100 comprises at least one scanning exposure 120.

The or each scanning exposure 120 comprises a step 122 of: moving the first object 200 and the second object 202 in the first direction such that they sequentially scan through a first illumination region IR the first illumination region IR is illuminated with radiation B.

The or each scanning exposure 120 further comprises a step 124 of: capturing radiation scattered by the first and second objects 200, 202 and using it to form an image of the first and second objects 200, 202 in a second illumination region IR' while moving the substrate W through the second illumination region IR' such that an image of the first object 200 is formed on a first target region 20A of the substrate W and an image of the second object 202 is formed on a second target region 20B of the substrate W. The first target region 20A is separated from the second target region 20B by a third target region 20C.

The two objects 200, 202 are shown in Figures 6A to 6B. Also shown is the first (or reticle-level) illumination region IR and an arrow C showing how the first (or reticle-level) illumination region IR moves over the two objects 200, 202. As explained above, it will be appreciated that, in practice, this relative movement may be achieved by scanning the objects 200, 202 through the reticle-level illumination region IR in a direction opposite to the arrow C shown in Figures 6A and 6B. Figures 6A to 6B show the arrangement at three different points during a scanning exposure 120 process.

For at least part of the time when neither the first target region 20A nor second target region 20B overlaps with the second illumination region IR' the substrate W accelerates.

The exposure method 100 illustrated by Figures 5 to 7 may comprise a lithographic exposure method. The first object 200 and the second object 202 may comprise any type of patterning device MA (also referred to as a reticle or mask). The first illumination region IR may be disposed in an object plane (which may also referred to as a reticle-level illumination region). The second illumination region IR' may be disposed in an image plane (which may also referred to as a wafer-level illumination region). The first and/or second illumination region IR, IR' may be referred to as a slit (or exposure slit).

During the exposure method 100 a pattern may be formed on a plurality of target regions 20 of a substrate W. For example, the same pattern may be formed on a plurality of target regions 20 (also referred to as fields) of a resist-coated silicon wafer W. The pattern is defined by the first and second objects 200, 202, which each act as a patterning device MA (also referred to as a reticle or mask). Radiation B is patterned by these objects 200, 202 and then imaging optics PS may be used to form an image of each one on the wafer W. The pattern is transferred to the wafer W during a scanning exposure 120 in which the first and second objects 200, 202 are scanned through the first illumination region IR while the wafer W is also moved such that the image of each of the first and second objects 200, 202 is stationary with respect to the wafer W.

Within the lithographic field, reticles MA are expensive to manufacture. Reticles MA are typically formed from a reticle blank and reticle blanks are typically of a standard size (referred to as a 6" reticle blank). A first generation of EUV lithographic apparatus (also referred to as scanners) used spherical imaging optics PS with a reduction factor of 4 to form an image of a reticle (formed from a standard 6" reticle blank) that was reduced in both dimensions by the factor of 4. In order to increase the resolution of EUV lithography, the imaging optics PS of the next generation of EUV lithographic apparatus will have an increased numerical aperture (NA). Since EUV reticles MA are reflective, the EUV radiation is not normally incident on the reticle MA but rather is incident at a non-zero angle to a normal of the reticle MA in one direction (so that the incoming cone of radiation that is incident on the reticle is separate from the outgoing cone of radiation scattered by the reticle and which is accepted by the imaging optics). This direction is typically the scanning direction of the lithographic apparatus LA. In this direction, there is a limit to the extent to which the cone of radiation of the incoming radiation B can be enlarged without overlapping the scattered cone of radiation B' (unless the angle of incidence of the chief ray of the incoming radiation B is increased). However, it is undesirable to increase the angle of incidence of the chief ray of the incoming radiation B as this will increase 3D effects of the reticle, reducing contrast. Therefore, it has been proposed to use anamorphic imaging optics in the next generation of EUV lithographic apparatus such that, in the scanning direction, the reduction factor of the imaging optics PS is 8 whereas in the non-scanning direction the reduction factor remains 4 and the cone of light is enlarged only in the non-scanning direction.

However, one consequence of the increased reduction factor is that the field of view on the wafer W that can be imaged with a standard 6" reticle is now halved.

It may be desirable to form a pattern that is larger than the size that can be imaged with existing reticles MA (especially in the next generation of EUV lithographic apparatus LA using anamorphic imaging optics PS). Therefore, in some systems, each target region (field) may be exposed using two reticles, each of which defines the pattern of half of the field. However, such a half-field design increases the number of field-steps that need to be taken in order to expose the entire wafer W and therefore reduces the throughput of the lithographic apparatus LA as compared to a full-field system (in which the pattern of the entire field is defined by a single reticle MA). By default, the wafer W is exposed in two steps and a (slow) reticle swap is performed in between. This further reduces throughput of the system. The second exposure with the second reticle can be done in at least two different ways. A first method involves keeping the wafer W on a wafer stage WT and, once each field has been exposed using the first reticle, exchanging the reticle and exposing the wafer for the second time. However, this is very slow. A second method involves exposing a whole lot of wafers (e.g. 25 wafers) with one reticle, exchanging the reticle and then involves exposing the whole lot of wafers again. This can increase the throughput relative to the first method, however, the wafer is clamped on the wafer stage for less time each time it is exposed, which can limit the available time for measurements to be made once the wafer W has been clamped and before it is exposed (without again negatively impacting the lithographic throughout). For example, the available measurement time may be reduced by a factor of 2 since only half the amount of fields are exposed per wafer pass. As a consequence, the number of alignment marks that can be measured is halved. In addition, a buffer (also referred to as a stocker) is required to temporarily store the entire lot of wafers in between the first and second exposures.

Instead of exposing two half-fields separately as two different steps, with the exposure method 100 shown schematically in Figure 5 both reticles 200, 202 are exposed in a single stroke. Advantageously, this results in a measurement time that is comparable to that of the first generation of EUV lithographic apparatus LA (and therefore does not significantly reduce the number of alignment marks that can be measured). An image of the first object 200 (reticle) is formed on a first target region 20A (field) of the substrate W and an image of the second object 202 (reticle) is formed on a second target region 20B (field) of the substrate W, the first and second target regions 20A, 20B being separated by a third target region 20C. In between the formation of the images of first and second objects 200, 202 the wafer W is moved such that the third target region 20C traverses the second illumination region IR'. Advantageously, by accelerating the substrate W for at least part of the time when neither the first target region 20A nor second target region 20B overlaps with the second illumination region IR' the throughput of the method 100 is increased.

The two objects 200, 202 (reticles) can remain clamped to a reticle clamp during exposures of multiple lots of wafers. Both reticles are exposed during one scanning motion, with a short acceleration cycle between the two exposures.

In Figure 7, a portion of the first target region 20A of the substrate W on which the image of the first object is formed and a portion of the second target region 20B on which the image of the second object 202 is formed are shaded. The image of the first object 200 is formed on a portion of the first target region 20A of the substrate W that is adjacent to the third target region 20C. Similarly, the image of the second object 202 is formed on a portion of the second target region 20B that is adjacent to the third target region 20C. For example, each target region 20A, 20B, 20C may comprise two portions that are mutually adjacent in the first direction (the y-direction). Each of the two portions may comprise around a half of the target region 20A, 20B, 20C.

In some embodiments, the first object 200 and the second object 202 may be provided such that a gap 220 between them in the first direction (the y-direction) is greater than an extent 222 of the first illumination region IR in the first direction. That is, as shown in Figure 6B, the entire first illumination region IR can be disposed within the gap 220 between the first and second objects 200, 202. With such an arrangement, there is no temporal overlap between the formation of the images of the first and second objects 200, 202. Advantageously, this allows for the first illumination region IR to be masked (for example using reticle masking blades) in between the formation of the first and second images. This may reduce the risk that the third target region 20C is exposed to stray radiation.

In some embodiments, the first object 200 and the second object 202 may be provided such that a gap 220 between them in the first direction (the y-direction) is less than a combined extent of the first object 200 and the second object 202 in the first direction. That is, the gap 220 between the first object 200 and the second object 202 in the first direction (the y-direction) may be less than a sum of an extent 230 of the first object 200 in the first direction and an extent 232 of the second object 202 in the first direction.

Advantageously, such an arrangement allows for accelerations of the first object 200 and the second object 202 in the first direction to minimized.

For example, such an arrangement may allow for the movement of the first object 200 and the second object 202 in the first direction to be at a constant velocity, despite the fact that for at least part of the time when neither the first target region 20A nor second target region 20B overlaps with the second illumination region IR' the substrate accelerates W, as discussed below. It is particularly advantageous for the movement of the first object 200 and the second object 202 in the first direction to be at a constant velocity, particularly within a lithographic apparatus which applies a reduction factor. For example, for a lithographic apparatus having imaging optics that applies a reduction factor of 8 in the scanning direction, the first and second objects 200, 202 (the reticles) will already be moving 8 times faster than the substrate W (wafer). Therefore, any acceleration of the objects 200, 202 (reticles) will, in general, require significantly higher forces and energy to accelerate than the substrate W (wafer) and, in turn, this results in a higher risk of dynamic errors. Furthermore, any acceleration of the objects 200, 202 (reticles) will, in general, require faster electronics than would be required to accelerate the substrate W.

As is the case for the embodiment shown in Figure 7, the extent 230 of the first object 200 in the first direction may be substantially equal to the extent 232 of the second object 202 in the first direction. An extent 240, 242 of the images of the first object and second objects 200, 202 in the first direction may be substantially equal to half of an extent 244 of the plurality of target regions 20A, 20B, 20C (fields) in the first direction. Note that in other embodiments, the extent 230 of the first object 200 in the first direction may be different to the extent 232 of the second object 202 in the first direction. For example, the extent 232 of the second object 202 in the first direction may be smaller than the extent 230 of the first object 200 in the first direction. As a result, the extent 242 of the image of the second object 202 in the first direction may be smaller than an extent 240 of the image of the first object 200 in the first direction. In turn, this would result in a field having a different (for example smaller) extent 244 in the first direction.

As explained above, the method 100 shown schematically in Figure 5 may be used to expose half of a first field 20A with a first object 200 (for example defining a pattern A having extent 230) and half of a second field with a second object 202 (for example defining a pattern B having extent 232). At wafer-level, the images of the first object 200 and the second object 202 are separated by A'+B'+2g, where A' is the extent 240 of the image of the first object 200 at wafer level, B' is the extent 242 of the image of the second object 202 at wafer level and g is an extent of a gap between two adjacent fields 20A, 20B, 20C (also referred to as a scribe line) at wafer level W. Since g<<A' and g<<B' the distance between images of the first object and second objects is approximately A'+B'.

Note that, as used herein and shown in the Figures, pattern A (having extent 230) and pattern B (having extent 232) are portions of the first and second objects 200, 202 respectively that may contribute towards a device formed in the lithographic process. That is, pattern A and pattern B are intended to mean the parts of the first and second objects 200, 202 that define part of the integrated circuits being formed by the lithographic process. In practice, in addition to pattern A, the first object 200 may also define some other features that are imaged by the lithographic process and, similarly, in addition to pattern B, the second object 202 may also define some other features that are imaged by the lithographic process. For example, the first and second objects 200, 202 may each also define various metrology marks and targets (for example overlay marks) which may be imaged onto the scribe lanes of the wafer W. Therefore, although there is a non-zero gap g between the product portions of two adjacent fields 20A, 20B, 20C at wafer level W it will be appreciated that there are portions of the images of the first and second objects 200, 202 that will, in general, overlap with an images of of the first and second objects 200, 202 from adjacent fields 20A, 20B, 20C (these overlap portions being the scribe lanes where metrology marks may be formed).

Since, for at least part of the time when neither the first target region 20A nor the second target region 20B overlaps with the second illumination region IR' the substrate W accelerates, for the movement of the first object 200 and the second object 202 in the first direction to be at a constant velocity, the gap 220 between the first object 200 and the second object 202 in the first direction should be less than a combined extent of the first object 200 and the second object 202 in the first direction.

The substrate W may comprise a plurality of target regions 20. The or each target region 20 may be substantially rectangular. The plurality of target regions 20 may comprise a two-dimensional array of target regions 20 (for example as schematically shown in Figure 3). A plurality of target regions 20 that are at substantially the same position in the first direction (i.e. the y-direction) may be referred to as a row of target regions 20. A plurality of target regions 20 that are at substantially the same position in a second direction that is generally perpendicular to the first direction (i.e. the x-direction) may be referred to as a column of target regions 20.

In some embodiments of the method 100 shown in Figure 5, the method 100 may comprise a plurality of scanning exposures 120. For embodiments comprising a plurality of scanning exposures 120, the method 100 may comprise a step 130 of moving the wafer W in between successive scanning exposures 120. As explained further below with reference to Figures 8 to 10, the plurality of scanning exposures 120 may be performed as a modified type of meander scan (which is suggested in Figure 7 by curved dotted lines at each end of the straight dotted line which represents the scanning movement of a single scanning exposure 120).

In some embodiments, the plurality of scanning exposures 120 may result in an image of the first object 200 and an image of the second object 202 being formed in each of a plurality of target regions 20 (for example, each of the target regions shown in Figure 3).

In some embodiments, the plurality of target regions 20 may comprise a two-dimensional array of target regions 20 (for example as schematically shown in Figure 3).

In some embodiments, the image of the first object 200 formed on a target region 20 of the substrate W during one scanning exposure 120 may be stitched to the image of the second object 202 formed on that target region 20 of the substrate during another scanning exposure 120. For example, the images of the first object 200 and the second object 202 that are stitched may be mutually adjacent in the first direction (i.e. the y-direction in the Figures). That is, the two images that are stitched are mutually adjacent in the scanning direction (i.e. the y-direction in the Figures). Put differently, a join line between the two images that are stitched may extend in a second direction (a non-scanning direction, i.e. the x-direction in the Figures).

In some embodiments of the method 100 shown in Figure 5, the method 100 comprises a plurality of scanning exposures 120 and at least two sequential scanning exposures 120 of the plurality of scanning exposures 120 each comprise: forming an image of the first object 200 on a target region 20 from a first row of target regions of the substrate W and forming an image of the second object 202 on a target region 20 from a second row of target regions of the substrate W.

For example, in some embodiments, the at least two sequential scanning exposures 120 of the plurality of scanning exposures may comprise forming an image of the first object 200 on all of the target regions 20 from the first row of target regions of the substrate W and forming an image of the second object 202 on all of the target regions from 20 the second row of target regions of the substrate W.

The at least two sequential scanning exposures 120 of the plurality of scanning exposures 120 may be performed as a meander scan. That is, the movement of the substrate W during one of the at least two sequential scanning exposures 120 of the plurality of scanning exposures 120 may be in an opposite direction to movement of the substrate W during the preceding one of the at least two sequential scanning exposures 120 of the plurality of scanning exposures 120. Such embodiments are now described with reference to Figure 8.

The plurality of scanning exposures 120 illustrated in Figure 8 are performed as a modified type of meander scan. Figure 8 depicts a plurality of scanning exposures 120 (each one represented by a straight dotted line). The plurality of scanning exposures 120 shown in Figure 8 each comprise: forming an image of the first object 200 on a target region 20 from a first row of target regions 30A of the substrate W and forming an image of the second object 202 on a target region 20 from a second row 30B of target regions of the substrate W. Each one of the plurality of scanning exposures 120 shown in Figure 8 comprises forming these images of the first and second objects 200, 202 on target regions 20 from different columns of target regions 32A, 32B, 32C, ..., 32N.

In Figure 8, the portions of the target regions from the first and second rows of target regions 30A, 30B of the substrate W on which the images of the first and second objects 200, 202 are formed are shaded.

In this embodiment, the plurality of scanning exposures 120 comprise forming an image of the first object 200 on all of the target regions 20 from the first row of target regions 30A of the substrate W and forming an image of the second object 202 on all of the target regions from 20 the second row of target regions 30B of the substrate W.

The plurality of sequential scanning exposures 120 shown in Figure 8 are performed as a meander scan. That is, the movement of the substrate W during one of the at least two sequential scanning exposures 120 of the plurality of scanning exposures 120 is in an opposite direction to movement of the substrate W during the preceding one of the at least two sequential scanning exposures 120 of the plurality of scanning exposures 120.

In some embodiments of the method 100 shown in Figure 5, the method 100 comprises a first set of sequential scanning exposures 120 of the plurality of scanning exposures 120 each comprising: forming an image of the first object 200 on a target region 20 from a first row of target regions 30A of the substrate W and forming an image of the second object 202 on a target region 20 from a second row 30B of target regions of the substrate W. The first set of sequential scanning exposures 120 may form an image of the first object 200 on substantially all of the target regions 20 of the first row of target regions 30A and may form an image of the second object 202 on substantially all of the target regions 20 of the second row of target regions 30B.

The embodiment of the method 100 shown schematically in Figure 8 can be extended, as now described with reference to Figures 9 and 10.

In some embodiments of the method 100 shown in Figure 5, the method 100 comprises a plurality of sets of sequential scanning exposures 120 wherein each scanning exposure 120 from a given one of the plurality of sets of sequential scanning exposures 120 comprises: forming an image of the first object 200 on a target region from a first row of target regions of the substrate W and forming an image of the second object 202 on a target region from a second row of target regions of the substrate W; and wherein scanning exposures 120 from different sets of sequential scanning exposures 120 comprise: forming an image of the first object 200 on target regions from different rows of target regions 20 of the substrate W and forming an image of the second object 202 on target regions from different rows of target regions 20 of the substrate W.

In this way, a plurality of rows of target regions may be exposed to images of both the first and second objects 200, 202. A given target region (for example from a central portion of the substrate W) may be exposed to an image of the first object 200 during an exposure from one of the sets of sequential scanning exposures 120 and may be exposed to an image of the second object 202 during an exposure from another one of the sets of sequential scanning exposures.

The plurality of scanning exposures 120 illustrated in Figure 8 may be considered to be a first set of scanning exposures 120. In Figure 9, a second, subsequent set of scanning exposures 120 is illustrated. The portions of the first and second rows of target regions 30A, 30B that have already been exposed during the first set of scanning exposures 120 (cf. Figure 8) are shown in grey in Figure 9.

In addition, Figure 9 depicts the second set of scanning exposures 120 (each one represented by a straight dotted line) currently being performed. The plurality of scanning exposures 120 shown in Figure 9 each comprise: forming an image of the first object 200 on a target region 20 from one row of target regions 30C (which may be referred to as a third row 30C of target regions) of the substrate W and forming an image of the second object 202 on a target region 20 from another row 30D of target regions (which may be referred to as a fourth row 30D of target regions) of the substrate W. Each one of the plurality of scanning exposures 120 shown in Figure 9 comprises forming these images of the first and second objects 200, 202 on target regions 20 from different columns of target regions 32A, 32B, 32C, ..., 32N.

The plurality of scanning exposures 120 illustrated in Figure 8 may be considered to be a first set of scanning exposures 120 and the plurality of scanning exposures 120 illustrated in Figure 9 may be considered to be a second set of scanning exposures 120. In Figure 10, a third, subsequent set of scanning exposures 120 is illustrated. The portions of the first and second rows of target regions 30A, 30B that have already been exposed during the first and second sets of scanning exposures 120 (cf. Figures 8 and 9) are shown in grey in Figure 10.

In addition, Figure 10 depicts the third set of scanning exposures 120 (each one represented by a straight dotted line) currently being performed. The plurality of scanning exposures 120 shown in Figure 10 each comprise: forming an image of the first object 200 on a target region 20 from one row of target regions 30B (which may be referred to as a second row 30B of target regions) of the substrate W and forming an image of the second object 202 on a target region 20 from another row 30E of target regions (which may be referred to as a fifth row 30E of target regions) of the substrate W. Each one of the plurality of scanning exposures 120 shown in Figure 10 comprises forming these images of the first and second objects 200, 202 on target regions 20 from different columns of target regions 32A, 32B, 32C, ..., 32N.

Note that after this third set of scanning exposures 120 the target regions from the second row 30B of target regions have now been fully exposed: half exposed to pattern A and half exposed to pattern B.

In some embodiments of the method 100 shown in Figure 5, at least two sequential scanning exposures 120 of the plurality of scanning exposures 120 may comprise: forming an image of the first object 200 on target regions 20 from different rows of target regions of the substrate W and forming an image of the second object 202 on target regions from different rows of target regions of the substrate W. For example, the last scanning exposure (of column 32N) from the first set of scanning exposures shown in Figure 8 and the first scanning exposure (also of column 32N) from the second set of scanning exposures shown in Figure 9 are two sequential scanning exposures 120 that comprise forming an image of the first object 200 on target regions 20 from different rows of target regions of the substrate W (rows 30A and 30C respectively) and forming an image of the second object 202 on target regions from different rows of target regions of the substrate W (rows 30B and 30D respectively).

In general, each target region 20 is exposed to an image of a first object 200 during a first scanning exposure 120 and exposed to an image of a second object 202 during a second scanning exposure 120.

In some embodiments of the method 100 shown in Figure 5, at least one scanning exposure of the plurality of scanning exposures comprises: forming an image of the first object 200 or the second object 202 on a target region 20 of the substrate W. That is, at least one scanning exposure 120 only involves forming the image of one of the two objects 200, 202 on the substrate W. For example one or more rows of target regions 20 may be exposed to the images of the first or second objects 200, 202 using such exposure processes.

In some embodiments, target regions 20 from a plurality of rows of target regions 20 in a central portion of the substrate W may be exposed using: (a) a first scanning exposure in which an image of first object 200 is formed on that target region and an image of the second object 202 is formed on another target region; and (a) a second scanning exposure in which an image of second object 202 is formed on that target region and an image of the first object 200 is formed on yet another target region. As used here the first and second scanning exposures may be performed in any order. The target regions shown in the second row 30B of target regions shown in Figures 8 to 10 are examples of such target regions 20 in a central portion of the substrate W.

However, for any given column 32A-32N of target regions on a substrate (i.e. any line of target regions extending in the first direction or scanning direction or y-direction) two target regions at each end of the column may be exposed using: (a) a first scanning exposure in which an image of one of the first and second objects 200, 202 is formed on that target region and an image of the other one of the first and second objects 202, 200 is formed on another target region; and (a) a second scanning exposure in which only an image of the other one of the first and second objects 202, 200 is formed on that target region. Again, as used here the first and second scanning exposures may be performed in any order. The target regions shown in the first and third rows 30A, 30C of target regions shown in Figures 8 to 10 may be examples of such target regions 20 that are at one end of a column of target regions.

Therefore, in some embodiments of the method 100 shown in Figure 5, the method 100 may comprise at least one set of sequential scanning exposures 120 which each comprise: forming an image of only the first object 200 or the second image 202 on a target region 20 from a row of target regions of the substrate W.

In some embodiments of the method 100 shown in Figure 5, a plurality of columns 32A-32N of target regions may be exposed to an image of the first object 200 and an image of the second object 202 and wherein for two target regions at each end of each column 32A-32N the image of one of the first or second objects 200, 202 is formed during a scanning exposure in which only said image of one of the first or second objects 200, 202 is formed.

In the embodiments discussed above with reference to Figures 8 to 10, a modified meander scan is used. During each "row" of the meander can an image A of the first object 200 is formed on a first row of target regions and an image B of the second object 202 is formed on a second row of target regions. In general, this is repeated until all of the target regions have been fully exposed to both images A, B. It will be appreciated that these "rows" of the modified meander scan may be performed in any order and that the order shown in Figures 8 to 10 is only one example order.

In the embodiments discussed above with reference to Figures 8 to 10, the target regions from the second row 30B of target regions have now been exposed to pattern A (see Figure 10) and exposed to pattern B (see Figure 8). In particular, each target region in the second row 30B of target regions have been exposed to pattern A (see Figure 10) using a first scanning direction and exposed to pattern B (see Figure 8) using the same scanning direction. For example, consider the target region from the second row 30B and the first column 32A, which is exposed to pattern B with a scanning direction in the positive y-direction (see Figure 8) and is exposed to pattern A with a scanning direction that is also in the positive y-direction (see Figure 10). Such an order of "rows" of the modified meander scan may be preferred, for example, over embodiments wherein the two parts of the target region are exposed using opposite scanning directions. This may be because when the same scanning direction is used the stitching between the images of pattern A and pattern B may be less affected by heating of the substrate, and any distortion that results from this heating, than when the two parts of the target region are exposed using opposite scanning directions. Therefore, advantageously, the pattern shown in Figures 8 to 10, and as described above, wherein the two images are formed using the same scanning direction may allow for the more accurate stitching between the two images (pattern A and pattern B) to be achieved.

Therefore, in some embodiments, a plurality of scanning exposures 120 are performed that result in an image of the first object 200 and an image of the second object 202 being formed in each of a plurality of target regions and, for each of the plurality of target regions, a scanning direction used to form the image of the first object 200 is the same as the scanning direction used to form the image of the second object 202.

Figure 11A shows a graph 300 that represents the position of the substrate W as a function of time during two successive scanning exposures 120 of the method 100 shown in Figure 5 from the same set of successive scanning exposures 120 during a meander scan of the type described above with reference to Figures 8 and 10. Similarly, Figure 11B shows a graph 320 that represents the velocity in the scanning direction (i.e. in the y-direction) of the substrate W as a function of time during exposure of two successive scanning exposures 120 of the method 100 shown in Figure 5 from the same set of successive scanning exposures 120 during a meander scan of the type described above with reference to Figures 8 and 10.

Figure 12A shows a graph 340 that represents the position of a reticle stage (that supports the two objects 200, 202) as a function of time during two successive scanning exposures 120 of the method 100 shown in Figure 5 from the same set of successive scanning exposures 120 during a meander scan of the type described above with reference to Figures 8 and 10. Similarly, Figure 12B shows a graph 360 that represents the velocity in the scanning direction (i.e. in the y-direction) of the reticle stage (that supports the two objects 200, 202) as a function of time during exposure of two successive scanning exposures 120 of the method 100 shown in Figure 5 from the same set of successive scanning exposures 120 during a meander scan of the type described above with reference to Figures 8 and 10.

A first portion 302, 322, 342, 362 of each the graphs 300, 320, 340, 360 represents a portion of the meander scan during which the reticle stage (supporting the two objects 200, 202) and the substrate W accelerate from rest at one end of the scanning motion. During this first portion 302, 322, 342, 362 the objects 200, 202 and the substrate W each accelerate from rest (i.e. zero speed) up to a scanning speed, *vₛ,* in a first direction (the positive y-direction). It will be appreciated that the scanning speed, *vₛ,* will be different for the objects 200, 202 and the substrate W due to any reduction factor caused by the imaging optics PS (for example, the scanning speed of the objects 200, 202 may be greater than the scanning speed of the substrate W by a factor of 8).

A second portion 304, 324, 344, 364 of each the graphs 300, 320, 340, 360 represents a portion of the meander scan during which an image of the first object 200 is formed on a first target region 20 (for example the target region from row 30A and column 32A in Figure 8). During the second portion 304, 324, 344, 364 of each the graphs 300, 320, 340, 360 the objects 200, 202 and the substrate W each move at constant speed (the scanning speed *vₛ*).

A third portion 306, 326, 346, 366 of each the graphs 300, 320, 340, 360 represents a portion of the meander scan in between forming an image of the first object 200 on a first target region 20 (for example the target region from row 30A and column 32A in Figure 8) and forming an image of the second object 202 on a second target region 20 (for example the target region from row 30B and column 32A in Figure 8). As explained above, during the third portion 306, 326 of each of the graphs 300, 320 the substrate W, when neither the first target region nor the second target region overlaps with the second illumination region IR', the substrate W accelerates. For example, as shown in Figures 11A and 11B, during the third portion 306, 326 of each of the graphs 300, 320 the substrate W may accelerate from an exposure scanning speed *vₛ* to a higher speed *v*₁ and then back down to the exposure scanning speed *vₛ*. In contrast, during the third portion 346, 366 of each the graphs 340, 360 the two objects 200, 202 may continue to move at constant speed.

A fourth portion 308, 328, 348, 368 of each the graphs 300, 320, 340, 360 represents a portion of the meander scan during which an image of the second object 202 is formed on a first target region 20 (for example the target region from row 30B and column 32A in Figure 8). During the fourth portion 308, 328, 348, 368 of each the graphs 300, 320, 340, 360 the objects 200, 202 and the substrate W each move at constant speed (the scanning speed *vₛ*).

A fifth portion 310, 330, 350, 370 of each the graphs 300, 320, 340, 360 represents a portion of the meander scan during which the objects 200, 202 and the substrate W decelerate from moving at the scanning speed, *vₛ,* in the first direction (positive y-direction) to rest and then accelerate from rest up to the scanning speed, *vₛ,* in a second direction (the negative y-direction).

A sixth portion 312, 332, 352, 372 of each the graphs 300, 320, 340, 360 represents a portion of the meander scan during which an image of the second object 202 is formed on a first target region 20 (for example the target region from row 30B and column 32B in Figure 8). During the sixth portion 312, 332, 352, 372 of each the graphs 300, 320, 340, 360 the objects 200, 202 and the substrate W each move at constant speed (the scanning speed *vₛ*).

A seventh portion 314, 334, 354, 374 of each the graphs 300, 320, 340, 360 represents a portion of the meander scan in between forming an image of the second object 202 on a first target region 20 (for example the target region from row 30B and column 32B in Figure 8) and forming an image of the first object 200 on a second target region 20 (for example the target region from row 30A and column 32B in Figure 8). As explained above, during the seventh portion 314, 334 of each of the graphs 300, 320 the substrate W, when neither the first target region nor the second target region overlaps with the second illumination region IR', the substrate W accelerates. For example, as shown in Figures 11A and 11B, during the seventh portion 314, 334 of each of the graphs 300, 320 the substrate W may accelerate from an exposure scanning speed *vₛ* to a higher speed *v*₁ and then back down to the exposure scanning speed *vₛ.* In contrast, during the seventh portion 354, 374 of each the graphs 340, 360 the two objects 200, 202 may continue to move at constant speed.

An eighth portion 316, 336, 356, 376 of each the graphs 300, 320, 340, 360 represents a portion of the meander scan during which an image of the first object 200 is formed on a first target region 20 (for example the target region from row 30A and column 32B in Figure 8). During the eighth portion 316, 336, 356, 376 of each the graphs 300, 320, 340, 360 the objects 200, 202 and the substrate W each move at constant speed (the scanning speed *vₛ*).

A ninth portion 318, 338, 358, 378 of each the graphs 300, 320, 340, 360 represents a portion of the meander scan during which the objects 200, 202 and the substrate W deaccelerate from the scanning speed, *vₛ,* in the second direction (the negative y-direction) to rest.

Some embodiments of the present disclosure relate to an exposure apparatus. An example of such an exposure apparatus 400 is shown schematically in Figure 13.

The exposure apparatus 400 comprises: a first object support 410 configured to support a first object 200; and a second object support 420 configured to support a second object 202. The exposure apparatus 400 further comprises a controller 430 operable to implement the method 100 shown in Figure 5 and described above. In order to achieve this the controller 430 may, for example, be able to send one or more control signals s₁, s₂. The controller 430 may, for example, be able to send a control signal s₁ so as to control, for example, a position of the first and second object supports 410, 420 (which, in use, support first and second objects 200, 202). The controller 430 may, for example, be able to send one or more control signals s₂ so as to control, for example, a position of a substrate W supported by a substrate table WT.

As indicated by arrow 414, the first object support 410 and the second object support 420 are movable relative to the illumination region IR.

It will be appreciated that the exposure apparatus 100 shown in Figure 13 may comprise one or more optional features, as now discussed.

Optionally, the exposure apparatus 400 may comprise imaging optics 440, which may be configured to form an image of the first illumination region IR in a second illumination region IR'. The imaging optics 440 may be generally analogous to the projection system PS shown in Figure 1 and as described above. The imaging optics 440 may also be anamorphic such that a reduction factor of the image in the first direction is greater than a reduction factor of the image in a second direction that is generally perpendicular to the first direction. In Figure 13 the second direction is into the page (and may be referred to as the x-direction).

The first object support 410 may comprise an electrostatic clamp 412. Similarly, the second object support 420 comprises an electrostatic clamp 422.

Optionally, the imaging optics 440 may be configured such that a reduction factor of the image in the direction in which the first object support 410 is offset from the second object support 420 is 8 and a reduction factor of the image in a second direction that is generally perpendicular to the first direction is 4.

The exposure apparatus 400 may comprise illumination optics 450 configured to illuminate the first illumination region IR, through which an object 200, 202 supported by the first object support 410 and/or the second object support 420 can be moved, with radiation 452. The illumination optics 450 may be generally analogous to the illumination system IL shown in Figure 1 and as described above.

The exposure apparatus 100 may further comprise a radiation source 460 operable to produce the radiation. For example, the radiation source 460 may be operable to produce radiation 462 which is received by the illumination optics 450. The illumination optics 450 may be operable to receive the radiation beam 462 produced by the radiation source 460 and to produce therefrom the radiation 452 which illuminates the first illumination region IR.

The radiation 462 may comprise EUV radiation. The radiation source 460 may comprise a laser-produced plasma (LPP) radiation source. For example, the radiation source 460 may be generally of the form of to the radiation source SO shown in Figure 1 and as described above.

The exposure apparatus 400 may further comprise and a substrate table WT configured to support a substrate W such that it is disposed in, and movable through, the second illumination region IR'.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An exposure method for forming a pattern on a plurality of target regions of a substrate, the exposure method comprising:
providing a first object defining a first portion of the pattern and a second object defining a second portion of the pattern, such that the first object is adjacent to, and generally coplanar with, the second object, the first object offset from the second object in a first direction; and
at least one scanning exposure, the or each scanning exposure comprising:
moving the first object and the second object in the first direction such that they sequentially scan through a first illumination region while the first illumination region is illuminated with radiation; and
capturing radiation scattered by the first and second objects and using it to form an image of the first and second objects in a second illumination region while moving the substrate through the second illumination region such that an image of the first object is formed on a first target region of the substrate and an image of the second object is formed on a second target region of the substrate;
wherein the first target region is separated from the second target region by a third target region; and
wherein for at least part of the time when neither the first target region nor second target region overlaps with the second illumination region the substrate accelerates.

2. The method of claim 1 wherein the image of the first object is formed on a portion of the first target region of the substrate that is adjacent to the third target region and wherein the image of the second object is formed on a portion of the second target region that is adjacent to the third target region.

3. The method of any preceding claim wherein the first object and the second object are provided such that a gap between them in the first direction is greater than an extent of the first illumination region in the first direction.

4. The method of any preceding claim wherein the first object and the second object are provided such that a gap between them in the first direction is less than a combined extent of the first object and the second object in the first direction.

5. The method of any preceding claim wherein the method comprises a plurality of scanning exposures.

6. The method of claim 5 wherein the plurality of scanning exposures result in an image of the first object and an image of the second object being formed in each of a plurality of target regions.

7. The method of claim 6 wherein for each of the plurality of target regions, a scanning direction used to form the image of the first object is the same as the scanning direction used to form the image of the second object.

8. The method of claim 6 or claim 7 wherein the plurality of target regions comprises a two-dimensional array of target regions.

9. The method of any one of claims 6 to 8 wherein the image of the first object formed on a target region of the substrate during one scanning exposure is stitched to the image of the second object formed on that target region of the substrate during another scanning exposure.

10. The method of claim 9 wherein the images of the first object and the second object that are stitched are mutually adjacent in the first direction.

11. The method of any preceding claim when dependent either directly or indirectly on claim 5 wherein at least two sequential scanning exposures of the plurality of scanning exposures comprise:
forming an image of the first object on a target region from a first row of target regions of the substrate and forming an image of the second object on a target region from a second row of target regions of the substrate.

12. The method of claim 11 wherein the method comprises a first set of sequential scanning exposures of the plurality of scanning exposures and wherein each of the first set of sequential scanning exposures comprises:
forming an image of the first object on a target region from a first row of target regions of the substrate and forming an image of the second object on a target region from a second row of target regions of the substrate.

13. The method of claim 12 wherein the method comprises a plurality of sets of sequential scanning exposures of the plurality of scanning exposures;
wherein each scanning exposure from a given one of the plurality of sets of sequential scanning exposures comprises: forming an image of the first object on a target region from a first row of target regions of the substrate and forming an image of the second object on a target region from a second row of target regions of the substrate; and
wherein scanning exposures from different sets of sequential scanning exposures comprise: forming an image of the first object on target regions from different rows of target regions of the substrate and forming an image of the second object on target regions from different rows of target regions of the substrate.

14. The method of any one of claims 11 to 13 wherein a movement of the substrate during one of the at least two sequential scanning exposures and/or one of the plurality of sets of sequential scanning exposures of the plurality of scanning exposures is in an opposite direction to a movement of the substrate during the preceding one of the at least two sequential scanning exposures and/or the first set of sequential scanning exposures of the plurality of scanning exposures.

15. The method of any preceding claim when dependent either directly or indirectly on claim 5 at least two sequential scanning exposures of the plurality of scanning exposures comprise:
forming an image of the first object on target regions from different rows of target regions of the substrate and forming an image of the second object on target regions from different rows of target regions of the substrate.

16. The method of any preceding claim when dependent either directly or indirectly on claim 5 wherein at least one scanning exposure of the plurality of scanning exposures comprises: forming an image of the first object or the second object on a target region of the substrate.

17. The method of claim 16 wherein the method comprises a second set of sequential scanning exposures of the plurality of scanning exposures, which each comprise:
forming an image of only the first object or the second image on a target region from a first row of target regions of the substrate.

18. The method of any preceding claim wherein a plurality of columns of target regions are exposed to an image of the first object and an image of the second object and wherein for two target regions at each end of each column the image of one of the first or second objects is formed during a scanning exposure in which only said image of one of the first or second objects is formed.

19. The method of any preceding claim wherein for the or each scanning exposure in which an image of the first object is formed on a first target region of the substrate and an image of the second object is formed on a second target region of the substrate, the first target region being separated from the second target region by a third target region, and when neither the first target region nor second target region overlaps with the second illumination region the substrate accelerates from an exposure scanning speed to a higher speed and then back down to the exposure scanning speed.

20. An exposure apparatus comprising:
a first object support configured to support a first object;
a second object support configured to support a second object; and
a controller operable to implement the method of any preceding claim.
